# EUROPEAN PATENT SPECIFICATION

(11) **EP 1 737 051 B1**
(45) Date of publication and mention of the grant of the patent: **17.01.2018**
(21) Application number: 06115376.3
(22) Date of filing: 13.06.2006
(51) Int. Cl.: H01L 33/54, G02B 3/04, G02B 27/09, G02F 1/1335

(54) **Backlight assembly including light emitting diode and display device including the same**
Rückbeleuchtungsanordnung mit lichtemittierender Diode und Anzeigevorrichtung damit
Dispositif de rétroéclairage comprenant une diode électroluminescente et dispositif d'affichage associé.

(30) Priority: 24.06.2005 KR 2005054962
(43) Date of publication of application: 27.12.2006
(73) Proprietor: LG Display Co., Ltd., Youngdungpo-gu, Seoul (KR)
(72) Inventor: JEON, Seong-Man, 156-772, Seoul (KR)
(74) Representative: Viering, Jentschura & Partner mbB Patent- und Rechtsanwälte

(56) References cited:
- EP-A- 0 945 673
- EP-A- 1 376 708
- EP-A1- 1 659 641
- EP-A2- 1 486 818
- WO-A-01/83264
- WO-A-2006/103582
- WO-A1-02/101842
- WO-A1-2004/102683
- JP-A- 8 255 934
- JP-A- S61 127 186
- JP-A- 2001 351 424
- JP-U- H 073 154
- US-A- 4 907 044
- US-A- 5 865 529
- US-A1- 2001 019 378
- US-B1- 6 502 956

## Description

The present invention claims the benefit of Korean Patent Application No. 2005-0054962, filed in Korea on June 24, 2005.

### TECHNICAL FIELD

The present application relates to a display device and, more particularly, to a display device using a backlight assembly including a light emitting diode.

### BACKGROUND

WO 2004/102683 A1, EP 1 626 447 A1, JP 61 127186 A, US 5 865 529 A and US 4 907 044 A each disclose a light emitting diode, comprising: an emitting portion on a base portion; and a lens portion covering the emitting portion, contacting the emitting portion, refracting light emitted from the emitting portion, and having a slanted upper surface. WO 2004/102683 A1,

EP 1 626 447 A1, JP 61 127186 A and US 5 865 529 A further disclose that the slanted upper surface has a reversed cone shape. None of those documents disclose a reflector coated on the slanted upper surface. JP -H073154 U and WO02/101842 A1 both disclose a light emitting diode, comprising: an emitting portion on a base portion; a lens portion covering the emitting portion, contacting the emitting portion, refracting light emitted from the emitting portion, and having a slanted upper surface and a straight side surface connected to the slanted upper surface through a rounded edge portion, wherein the slanted upper surface has a reversed cone shape and a reflector coated on the slanted upper surface.

Display devices have typically used cathode-ray tubes (CRT). Presently, much effort has been made to study and develop various types of flat panel displays, such as liquid crystal display (LCD) devices, plasma display panels (PDP), field emission displays, and electro-luminescence displays (ELD), as a substitute for CRT. LCD devices have advantages over the other flat panel displays, some of the advantages are high resolution, light weight, thin profile, compact size, and low power supply requirements.

In general, an LCD device includes two substrates that are spaced apart and face each other with a liquid crystal material interposed between the two substrates. The two substrates include electrodes that face each other. A voltage applied between the electrodes induces an electric field across the liquid crystal material. Alignment of the liquid crystal molecules in the liquid crystal material changes in accordance with the intensity of the induced electric field, thereby changing the light transmissivity of the LCD device. Thus, the LCD device displays images by varying the intensity of the induced electric field.

Because the LCD device is a non-emissive type display device, a backlight is needed to supply the non-emissive type display device with light. A cold cathode fluorescent lamp (CCFL) or an external electrode fluorescent lamp (EEFL) has been used. Recently, a light emitting diode (LED) is used because it does not include mercury (Hg) and improves color display capability.

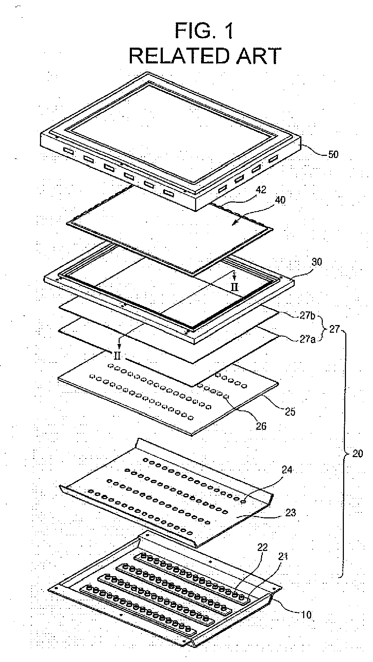

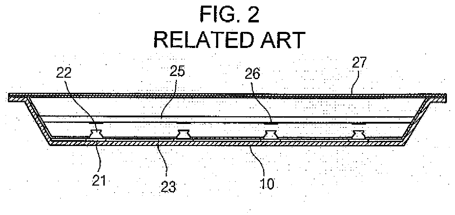

FIG. 1 is an exploded perspective view of an LCD module using an LED according to the related art, and FIG. 2 is a cross-sectional view taken along a line II-II of FIG. 1.

As shown in FIGs. 1 and 2, in the related art LCD module, a backlight assembly 20 and a liquid crystal panel 40 are sequentially disposed over a bottom case 10. A main supporter 30 has a rectangular frame shape and supports the backlight assembly 20 and the liquid crystal panel 40. The main supporter 30 is combined with the bottom case 10.

A driving circuit 42 is connected to the liquid crystal panel 40 through a flexible printed circuit board (FPCB). A top cover 50 is disposed on the top of the LCD panel. The top cover 50 presses and fixes a peripheral portion of the liquid crystal panel 40 and is combined with the main supporter 30 and the bottom case 10.

The backlight assembly 20 includes a plurality of LEDs 22, a reflecting sheet 23, a light guide plate 25, and optical sheets such as a prism sheet 27a and a diffusion sheet 27b. The LEDs 22 are arranged on a plurality of printed circuit boards (PCBs) 21. The PCBs 21 are arranged in parallel on the bottom case 10. The reflecting sheet 23 has a plurality of through holes 24. The through holes 24 correspond to the LEDs 22, and the reflecting sheet 23 covers the PCBs 21 and the bottom case 10. The light guide plate 25 is spaced apart from the LEDs 22 and has a plurality of reflecting dots 26. The reflecting dots 26 correspond to the LEDs 22. The optical sheets 27 are spaced apart from the light guide plate 25. The optical sheets 27 condense and diffuse light passing through the light guide plate 25.

The LEDs 22 includes red, green and blue color LEDs of the same number. The red, green and blue color LEDs simultaneously turn on to mix red, green and blue colors, thereby forming a white color light.

To mix the colors, a side emission type LED is used in the related art LCD module. The side emission type LED emits light sideward. If light emitted from a color LED 22 goes directly upward, the light is not sufficiently mixed with light emitted from other color LEDs 22, and thus a color spot is generated and displayed as the inherent color of the LED through the liquid crystal panel 40. Therefore, because the side emission type LED does not emit light upward it is commonly used.

The related art LED 22 has the highest luminous intensity at an emission angle of about 80 degrees with respect to a vertical center axis of the LED 22. In other words, most of the light is emitted within the vicinity of 80 degrees from the LED 22 to form a white color light.

However, a portion of the light emitted from the LED 22 still goes directly upward. Approximately, five to eight percent of the entire amount of light emitted from the LED goes directly upward. This ratio is enough to cause the color spot.

To prevent the color spot in the related art, the light guide plate 25 has reflecting dots 26 in the backlight assembly. The reflecting dots 26 are referred to as diverters. Similar to the reflecting sheet 23, the reflecting dots 26 reflect light.

Therefore, light directly emitted from one LED 22 or light reflecting from the reflecting dots 26 is mixed with emitted light from other LEDs 22 to form a white color light. Then, the white color light passes through the light guide plate 25 and the optical sheets 27 and is incident on the liquid crystal panel 40. The liquid crystal panel 40 uses the white color light to display images.

The light guide plate 25 is transparent but made of acrylic resin. Because acrylic resin partially absorbs or reflects light, the light guide plate 25 reduces light efficiency by approximately ten percent. To resolve a reduction in the light efficiency the power consumption is increased.

Further, because the light guide plate 25 is disposed close to the LED 22, the light guide plate 25 and the LED 22 may become damaged when the LCD module is impacted or swung around. Therefore, reliability of the related art backlight assembly is reduced.

### SUMMARY

The invention provides a light emitting diode according to claim 1. Further embodiments of the invention are described in the dependent claims.

### BRIEF DESCRIPTION OF THE DRAWINGS

FIG. 1 is an exploded perspective view of an LCD module using an LED according to the related art;
FIG. 2 is a cross-sectional view taken along a line II-II of FIG. 1;
FIG. 3 is a cross-sectional view of an LED in a backlight assembly according to an exemplary embodiment not part of the present invention;
FIGs. 4A to 4C are simulation pictures illustrating mixing of colors in a backlight assembly without the light guide plate when highest luminous intensities are made at angles of about 40, 50 and 67.5 degrees, respectively, with respect to a vertical center axis of an LED;
FIGs. 5A and 5B are a polar coordinates diagram and an orthogonal coordinates diagram, respectively, illustrating an emitted light distribution from the LED having a slanted angle of about 67 degrees; and
FIG. 6 is a cross-sectional view of an LED according to an exemplary embodiment of the present invention.

### DETAILED DESCRIPTION OF THE PREFERRED EMBODIMENTS

Exemplary embodiments may be better understood with reference to the drawings, but these examples are not intended to be of a limiting nature. The LCD module according to exemplary embodiments has a structure similar to that of the LCD module of FIG. 1. Accordingly, detailed explanations of parts similar the LCD module of FIG. 1 may be omitted.

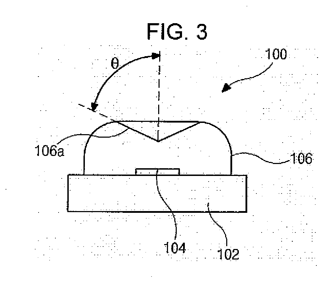

FIG. 3 is a cross-sectional view of an LED in a backlight assembly according to an exemplary embodiment not part of the present invention.

As shown in FIG. 3, the LED 100 according to the exemplary embodiment includes a base portion 102, an emitting portion 104 on the base portion 102, and a lens portion 106 covering the emitting portion 104. The lens portion 106 is transparent and refracts light emitted from the emitting portion 104 toward a side of the LED 100. The base portion 102 supplies an interface between an external LED operating system and the LED 100.

The lens portion 106 has a refractive index higher than air outside the lens portion 106. Accordingly, when light passes through the side surface of the lens portion 106, the refractive angle is higher than the incident angle according to Snell's principle. Therefore, most of the light emitted from the emitting portion 104 goes sideward and is mixed with light emitted from adjacent LEDs to form a white color light.

The lens portion 106 has a slanted upper surface 106a to prevent light going directly upward. The slanted upper surface 106a reflects light, which is travelling directly upward, toward a side surface of the LED 100, and thus the color spot is reduced. The slanted upper surface 106a may have a revered cone shape. The slanted upper surface 106a has a slanted angle θ of about 55 to 85 degrees with respect to a center axis of the LED 100. Because the slanted upper surface 106a has a slanted angle θ of about 55 to 85 degrees, most of the light traveling upward reflects from the slanted angle 106a towards the side surface of the lens portion 106. Because the LED 100 has the slanted upper surface 106a which has a slanted angle θ of 55 to 85 degrees, different color light emitted from adjacent LEDs 100 are uniformly mixed to form a white color. Accordingly, the LCD module of the exemplary embodiment does not need a light guide plate. Therefore, the color spot can be prevented without the use of a light guide plate, and also, reduction of light efficiency due to the light guide plate can be prevented.

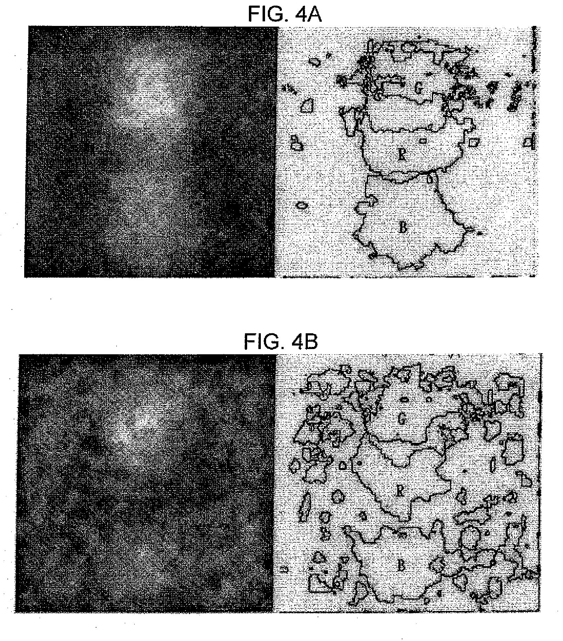

FIGs. 4A to 4C are simulation pictures illustrating mixing of colors in a backlight assembly without the light guide plate when the highest luminous intensities are created at angles of about 40, 50 and 67.5 degrees, respectively, with respect to a vertical center axis of an LED. For exemplary reasons, it was supposed that the backlight assembly of FIGs. 4A to 4C had a thickness of 40 millimeters which is the same as the thickness of the related art backlight assembly. The pictures at left sides of FIGs. 4A to 4C are pictures gray-scaled from color pictures. Because it is difficult to distinguish colors and color boundary by the gray-scaling, pictures which are made by extracting outlines of colors from the color pictures are accompanied at right sides of FIGs. 4A to 4C along with the gray-scaled pictures. Because the pictures at right sides are made by extracting outlines of colors from not the gray-scaled pictures but the color pictures, they may not appear to be the same as the corresponding gray-scaled pictures.

As shown in FIG. 4A, when the highest luminous intensity is created at an angle of about 40 degrees, the inherent colors of the LEDs (100 of FIG. 3) which are red, green and blue, appear directly over the LEDs, and thus the mixing of the colors was not effective. Therefore, the color spot is caused.

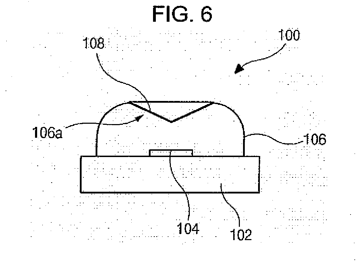

As shown in FIG. 4B, when the highest luminous intensity is created at an angle of about 50 degrees, mixing of colors is improved more than that of FIG. 6A, but inherent colors of the LEDs (100 of FIG. 3) still appear directly over the LEDs. Therefore, the color spot is still caused.

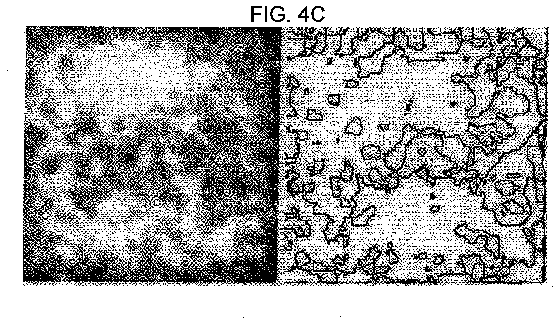

As shown in FIG. 4C, when a highest luminous intensity is made at an angle of about 67.5 degrees, inherent colors of the LEDs (100 of FIG. 3) do not appear directly over the LEDs, and thus the mixing of colors was effective. Therefore, the color spot is not caused.

The above simulated examples demonstrate that the color spot can be effectively prevented without use of a light guide plate when the highest luminous intensity is created at an angle of about 67.5 degrees. In addition, the color spot can also be effectively prevented without use of the light guide plate when the highest luminous intensity is created at an angle range of about 55 to 80 degrees. The highest luminous intensity will be created at an angle range of about 55 to 80 degrees when the slanted upper surface has a slanted angle of about 55 to 85 degrees.

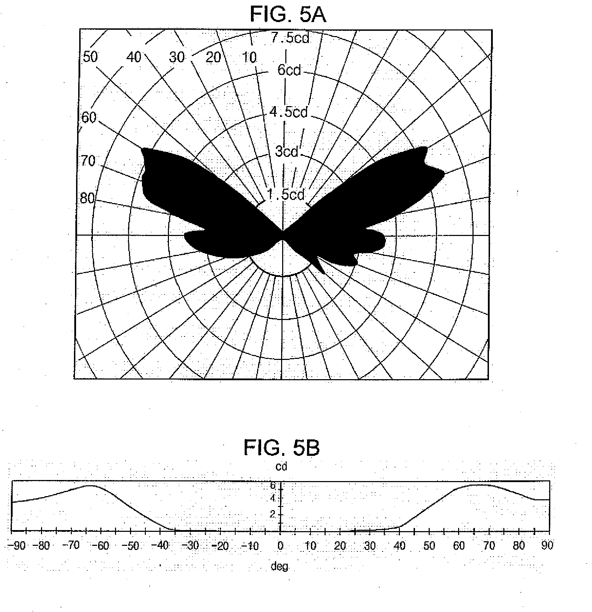

FIGs. 5A and 5B are a polar coordinates diagram and an orthogonal coordinates diagram, respectively, illustrating an emitted light distribution from the LED having a slanted angle of about 67 degrees.

As shown in FIGs. 5A and 5B, most of the light emitted from the LED (100 of FIG. 3) is distributed within an emission angle range of about 50 to 90 degrees, and the highest luminous intensity is created at an emission angle range of about 60 to 70 degrees.

In particular, light emitted from the LED does not go directly upward, i.e., the light emitted from the LED does not remain in the vicinity of an emission angle of 0 degree. When the light emitted from the LED is prohibited from traveling directly upward the color spot can be prevented. Thus, the light guide plate of the related art can be omitted in the backlight assembly of the exemplary embodiment. In experiment, when a ratio of a luminous intensity at 0 degree and a highest luminous intensity is equal to or less than 2 percent, the color spot can be substantially prevented without use of the light guide panel.

Although the LED of the exemplary embodiment is used, in experiment, when the bottom case has a height of 10 millimeters, the color spot may be caused. Therefore, the bottom case may have a height enough to prevent the color spot.

To prevent the color spot more effectively, the lens portion (106 of FIG. 3) may be made of a material having a refractive index of about 1.49 to 1.51, such as polymethylmethacrylate (PMMA) and silica.

FIG. 6 is a cross-sectional view of an LED according to an exemplary embodiment of the present invention.

As shown in FIG. 6, the LED 100 further includes a reflector 108, which is coated on the slanted upper surface 106a. The reflector 108 has a high reflectance to shield the emitted light going directly upward and may be made of a metal such as aluminum (Al).

As explained above, the LED of the exemplary embodiments has the slanted upper surface of the slanted angle of about 55 to 85 degrees. Accordingly, the entire amount of light emitted from the LED travels sideward and not upward. Thus, light emitted from one color LED can be effectively mixed with light emitted from the other color LEDs to form a white color light. Therefore, the backlight assembly of the exemplary embodiments does not need the light guide plate of the related art and light efficiency can increase. As a result, production cost can be reduced and reliability can be improved.

Another result of the the backlight assembly of the exemplary embodiments is that it supplies a white color light brighter than the related art. Therefore, the plurality of LEDs in the backlight assembly can be divided into several parts and the several parts can be sequentially operated.

Hereinafter, the LCD module of the exemplary embodiments is explained in brevity, with reference to FIGs. 1, 3 and 6. The LCD module of the exemplary embodiments is similar to the related art LCD module, except for use of the light guide plate and structure of the LED.

The backlight assembly 20 and the liquid crystal panel 40 are sequentially disposed on the bottom case 10. The main supporter 30 has a rectangular frame shape and supports the backlight assembly 20 and the liquid crystal panel 40. The main supporter 30 is combined with the bottom case 10.

The driving circuit is connected to the liquid crystal panel 40 through a flexible printed circuit board (FPCB). The top cover 50 is disposed on top of the LCD panel 40. The top cover 50 presses and fixes the peripheral portion of the liquid crystal panel 40 and is combined with the main supporter 30 and the bottom case 10.

The backlight assembly 20 includes a plurality of LEDs 100, the reflecting sheet 23 and the optical sheets 27 such as the prism sheet 27a and the diffusion sheet 27b. The LEDs 100 are arranged on a plurality of printed circuit boards (PCBs) 21. The PCBs 21 are arranged in parallel on the bottom case 10. The reflecting sheet 23 has the plurality of through holes 24. The through holes 24 correspond to the LEDs 22 and the reflecting sheet 23 covers the PCBs 21 and the bottom case 10. The optical sheets 27 are disposed directly over the LEDs 100 and condense and diffuse light emitted from the LEDs 100 and reflecting from the reflecting sheet 23. In other words, in the exemplary embodiments, because the light guide plate is not needed, the transparent portions of the optical sheets 27 are disposed directly over the LEDs 100, as opposed to the reflecting dots of the light guide plate.

The LEDs 100 includes red, green and blue color LEDs of the same number. The red, green and blue color LEDs may turn on simultaneously to mix colors, thereby forming a white color.

The backlight assembly of the exemplary embodiments can be applicable to other non-emissive type display devices.

It will be apparent to those skilled in the art that various modifications and variations can be made in the LCD device and the backlight assembly using the LEDs of the present invention without departing from the scope of the invention. Thus, it is intended that the present invention cover the modifications and variations of this invention provided they come within the scope of the appended claims and their equivalents.

## Claims

1. A light emitting diode (100), comprising:
an emitting portion (104) on a base portion (102);
a lens portion (106) covering the emitting portion, contacting the emitting portion, refracting light emitted from the emitting portion, and having a slanted upper surface (106a) and a straight side surface connected to the slanted upper surface through a rounded edge portion, wherein the slanted upper surface has a reversed cone shape and a slanted angle of about 55 to 85 degrees with respect to a center axis of the emitting portion, wherein the light emitting diode has a highest luminous intensity at an angle of about 55 to 80 degrees with respect to the center axis of the emitting portion; and
a reflector (108) coated on the slanted upper surface,
wherein a ratio of a luminous intensity at 0 degree with respect to the center axis of the emitting portion and the highest luminous intensity is equal to or less than 2 percent.

2. The diode according to claim 1, wherein the lens portion (106) has a refractive index of about 1.49 to 1.52.

3. The diode according to claim 1, wherein the lens portion (106) includes polymethylmetharylate (PMMA) and silica.

4. A backlight assembly (20), comprising:
a plurality of light emitting diodes (100) according to claims 1 to 3,
a reflecting sheet (23) having a plurality of through holes (24) corresponding to the plurality of light emitting diodes (100); and
at least one optical sheet (27) which includes a prism sheet (27a), being disposed directly over the plurality of light emitting diodes (100).

5. The assembly (20) according to claim 4, wherein portions of at least one optical sheet (27) directly over the plurality of light emitting diodes (100) are transparent.

6. A display device, comprising:
a display panel; and
a backlight assembly (20) below the display panel
wherein the backlight assembly (20) comprises:
a plurality of light emitting diodes (100) according to claims 1 to 3;
a reflecting sheet (23) having a plurality of through holes (24) corresponding to the plurality of light emitting diodes (100); and
at least one optical sheet (27) which includes a prism sheet (27a), being disposed directly over the plurality of light emitting diodes (100).

7. The device according to claim 6, wherein portions of the at least one optical sheet (27) directly over at least a portion of the plurality of light emitting diodes (100) are transparent.

8. The device according to claim 6, wherein the display panel includes a liquid crystal panel.

## Patentansprüche

1. Eine lichtemittierende Diode (100) aufweisend:
einen Emissionsabschnitt (104) auf einem Basisabschnitt (102);
einen Linsenabschnitt (106), welcher den Emissionsabschnitt bedeckt, den Emissionsabschnitt kontaktiert, von dem Emissionsabschnitt emittiertes Licht bricht und eine abgeschrägte obere Fläche (106a) und eine gerade Seitenfläche hat, die mit der abgeschrägten oberen Fläche durch einen abgerundeten Randabschnitt verbunden ist, wobei die abgeschrägte obere Fläche eine umgekehrte Kegelform und einen abgeschrägten Winkel von ungefähr 55 bis 85 Grad in Bezug auf eine Mittelachse des Emissionsabschnitts hat, wobei die lichtemittierende Diode eine höchste Leuchtintensität bei einem Winkel von ungefähr 55 bis 80 Grad in Bezug auf die Mittelachse des Emissionsabschnitts hat; und
einen Reflektor (108), mit welchem die abgeschrägte obere Fläche beschichtet ist, wobei ein Verhältnis einer Leuchtintensität bei 0 Grad in Bezug auf die Mittelachse des Emissionsabschnitts und der höchsten Leuchtintensität gleich oder kleiner als 2 Prozent ist.

2. Die Diode gemäß Anspruch 1, wobei der Linsenabschnitt (106) einen Brechungsindex von ungefähr 1,49 bis 1,52 hat.

3. Die Diode gemäß Anspruch 1, wobei der Linsenabschnitt (106) Polymethylmethacrylat (PMMA) und Siliziumdioxid aufweist.

4. Eine Hintergrundbeleuchtungseinrichtung (20) aufweisend:
eine Mehrzahl von lichtemittierenden Dioden (100) gemäß den Ansprüchen 1 bis 3,
eine reflektierende Platte (23), welche eine Mehrzahl von Durchgangslöchern (24) hat, die der Mehrzahl von lichtemittierenden Dioden (100) entsprechen; und
mindestens eine optische Platte (27), welche eine Prismenplatte (27a) aufweist, die direkt über der Mehrzahl von lichtemittierenden Dioden (100) angeordnet ist.

5. Die Einrichtung (20) gemäß Anspruch 4, wobei Abschnitte der zumindest einen optischen Platte (27) direkt über der Mehrzahl von lichtemittierenden Dioden (100) transparent sind.

6. Eine Anzeigevorrichtung aufweisend:
ein Anzeigepanel; und
eine Hintergrundbeleuchtungseinrichtung (20) unter dem Anzeigepanel, wobei die Hintergrundbeleuchtungseinrichtung (20) aufweist:
eine Mehrzahl von lichtemittierenden Dioden (100) gemäß den Ansprüchen 1 bis 3;
eine reflektierende Platte (23), welche eine Mehrzahl von Durchgangslöchern (24) aufweist, die der Mehrzahl von lichtemittierenden Dioden (100) entsprechen; und
mindestens eine optische Platte (27), welche eine Prismenplatte (27a) aufweist, die direkt über der Mehrzahl von lichtemittierenden Dioden (100) angeordnet ist.

7. Die Vorrichtung gemäß Anspruch 6, wobei Abschnitte der zumindest einen optischen Platte (27) direkt über mindestens einem Abschnitt der Mehrzahl von lichtemittierenden Dioden (100) transparent sind.

8. Die Vorrichtung gemäß Anspruch 6, wobei das Anzeigepanel ein Flüssigkristallpanel aufweist.

## Revendications

1. Diode électroluminescente (100) comprenant :
une portion émettrice (104) sur une portion de base (102) ;
une portion à lentille (106) recouvrant la portion émettrice, en contact avec la portion émettrice, réfractant la lumière émise à partir de la portion émettrice et ayant une surface supérieure inclinée (106a) et une surface latérale droite connectée à la surface supérieure inclinée par l'intermédiaire d'une portion de bord arrondie, la surface supérieure inclinée présentant une forme conique inversée et un angle incliné d'environ 55 à 85 degrés par rapport à un axe central de la portion émettrice, la diode électroluminescente présentant l'intensité lumineuse la plus élevée à un angle d'environ 55 à 80 degrés par rapport à l'axe central de la portion émettrice ; et
un réflecteur (108) revêtu sur la surface supérieure inclinée,
dans laquelle un rapport entre une intensité lumineuse à 0 degré par rapport à l'axe central de la portion émettrice et l'intensité lumineuse la plus élevée est inférieur ou égal à 2 %.

2. Diode selon la revendication 1, dans laquelle la portion à lentille (106) présente un indice de réfraction d'environ 1,49 à 1,52.

3. Diode selon la revendication 1, dans laquelle la portion à lentille (106) comprend du polyméthylméthacrylate (PMMA) et de la silice.

4. Ensemble de rétro-éclairage (20) comprenant :
une pluralité de diodes électroluminescentes (100) selon les revendications 1 à 3,
un film réfléchissant (23) comprenant une pluralité de trous traversants (24) correspondant à la pluralité de diodes électroluminescentes (100) ; et
au moins un film optique (27) qui comprend un film prismatique (27a) disposé directement au-dessus de la pluralité de diodes électroluminescentes (100).

5. Ensemble (20) selon la revendication 4, dans lequel des portions de l'au moins un film optique (27) directement au-dessus de la pluralité de diodes électroluminescentes (100) est transparent.

6. Dispositif d'affichage comprenant :
un panneau d'affichage ; et
un ensemble de rétro-éclairage (20) en dessous du panneau d'affichage l'ensemble de rétro-éclairage (20) comprenant :
une pluralité de diodes électroluminescentes (100) selon les revendications 1 à 3 ;
un film réfléchissant (23) comprenant une pluralité de trous traversants (24) correspondant à la pluralité de diodes électroluminescentes (100) ; et
au moins un film optique (27) qui comprend un film prismatique (27a) disposé directement au-dessus de la pluralité de diodes électroluminescentes (100).

7. Dispositif selon la revendication 6, dans lequel des portions de l'au moins un film optique (27) directement au-dessus d'au moins une portion de la pluralité de diodes électroluminescentes (100) est transparent.

8. Dispositif selon la revendication 6, dans lequel le panneau d'affichage comprend un panneau à cristaux liquides.
